# FASCICULE DE BREVET EUROPEEN

(11) **EP 4 214 760 B1**
(45) Date de publication et mention de la délivrance du brevet: **30.10.2024**
(21) Numéro de dépôt: 21773778.2
(22) Date de dépôt: 09.09.2021
(51) Int. Cl.: H01L 31/0216, H01L 31/0236, H01L 31/0224

(54) **PROCEDE DE FABRICATION D'UNE CELLULE PHOTOVOLTAÏQUE A CONTACTS PASSIVES**
VERFAHREN ZUR HERSTELLUNG EINER FOTOVOLTAISCHEN ZELLE MIT PASSIVEM KONTAKT
METHOD FOR MANUFACTURING A PASSIVE-CONTACT PHOTOVOLTAIC CELL

(30) Priorité: 21.09.2020 FR 2009530
(43) Date de publication de la demande: 26.07.2023
(73) Titulaire: Commissariat à l'Energie Atomique et aux Energies Alternatives, 75015 Paris (FR)
(72) Inventeur: CABAL, Raphaël, 38054 GRENOBLE Cedex 09 (FR); MARTEL, Benoît, 38054 GRENOBLE Cedex 09 (FR)
(74) Mandataire: INNOV-GROUP
(86) Numéro de dépôt international: PCT/EP2021/074853
(87) Numéro de publication internationale: WO 2022/058238

(56) Documents cités:
- WO-A1-2019/053368
- CN-A- 105 895 738
- US-A1- 2013 153 025
- US-A1- 2019 326 453
- US-A1- 2020 279 970
- US-B2- 9 406 820

## Description

### Domaine technique

L'invention se rapporte au domaine technique des cellules photovoltaïques.

L'invention trouve notamment son application dans la fabrication de cellules photovoltaïques de type PERT (« *Passivated Emitter Rear Total*/*y-diffused* » en langue anglaise).

### État de l'art

Un procédé de fabrication d'une cellule photovoltaïque connu de l'état de la technique, notamment du document FR 3 035 740, comporte les étapes :
a₀) prévoir une structure comprenant :
   - un substrat à base de silicium cristallin, présentant une première surface et une seconde surface opposée ;
   - une première couche diélectrique, comprenant des atomes de bore, et formée sur la première surface du substrat ;
   - une deuxième couche diélectrique, comprenant des atomes de phosphore, et formée sur la seconde surface du substrat ;
b₀) appliquer un traitement thermique à la structure de manière à :
   - diffuser les atomes de bore depuis la première couche diélectrique sous la première surface du substrat, de manière à former une première région semi-conductrice dopée destinée à être en contact avec une électrode ;
   - diffuser les atomes de phosphore depuis la seconde couche diélectrique sous la seconde surface du substrat, de manière à former une seconde région semi-conductrice dopée destinée à être en contact avec une électrode.

Un tel procédé de l'état de la technique permet de limiter le nombre d'étapes à exécuter grâce à la co-diffusion des atomes de bore et de phosphore, et à la conservation des première et deuxième couches diélectriques après l'étape b₀). A cet égard, l'étape b₀) est exécutée sous une atmosphère oxydante afin d'augmenter la passivation de la structure et autoriser la conservation des première et deuxième couches diélectriques. Par « passivation », on entend la neutralisation de défauts électriquement actifs aux première et seconde surfaces du substrat. En effet, le substrat à base de silicium cristallin comporte une densité de défauts (e.g. liaisons pendantes, impuretés, discontinuité du cristal...) pouvant entraîner des pertes non négligeables liées à la recombinaison en surface des porteurs dans le cas d'une application photovoltaïque.

Cependant, un tel procédé de l'état de la technique n'est pas entièrement satisfaisant en termes de passivation de la structure. L'homme du métier recherche à améliorer les performances de la cellule photovoltaïque avec des valeurs de tension de circuit ouvert V_{oc} les plus élevées possible.

Le document WO 2019/053368 A1 décrit un procédé de fabrication d'une cellule solaire à homojonction.

### Exposé de l'invention

L'invention vise à remédier en tout ou partie aux inconvénients précités. A cet effet, l'invention a pour objet un procédé de fabrication d'une cellule photovoltaïque, comportant les étapes successives :
a) prévoir une structure comprenant :
   - un substrat à base de silicium cristallin, présentant une première surface et une seconde surface opposée comportant chacune une zone polie et une zone texturée ;
   - des premier et deuxième films d'oxyde tunnel, formés respectivement sur la zone polie des première et seconde surfaces du substrat ;
   - des première et deuxième couches de polysilicium, formées respectivement sur les premier et deuxième films d'oxyde tunnel ;
   - une première couche diélectrique, comprenant des dopants de type p, formée sur la zone texturée de la première surface du substrat et sur la première couche de polysilicium ;
   - une deuxième couche diélectrique, comprenant des dopants de type n, formée sur la zone texturée de la seconde surface du substrat et sur la deuxième couche de polysilicium ;
b) appliquer un traitement thermique à la structure adapté pour :
   - diffuser les dopants de type p sous la première surface du substrat, depuis la première couche diélectrique formée sur la première couche de polysilicium, à travers la première couche de polysilicium et le premier film d'oxyde tunnel, de manière à former une première région semi-conductrice dopée ;
   - diffuser les dopants de type p sous la première surface du substrat, depuis la première couche diélectrique formée sur la zone texturée de la première surface du substrat, de manière à former une deuxième région semi-conductrice dopée ;
   - diffuser les dopants de type n sous la seconde surface du substrat, depuis la deuxième couche diélectrique formée sur la deuxième couche de polysilicium, à travers la deuxième couche de polysilicium et le deuxième film d'oxyde tunnel, de manière à former une troisième région semi-conductrice dopée ;
   - diffuser les dopants de type n sous la seconde surface du substrat, depuis la deuxième couche diélectrique formée sur la zone texturée de la seconde surface du substrat, de manière à former une quatrième région semi-conductrice dopée ;
c) mettre en contact chacune des première et deuxième couches de polysilicium avec une électrode.

### Définitions

- Par « substrat », on entend un support mécanique, autoporté, destiné à la fabrication d'une cellule photovoltaïque, classiquement une plaquette (« *wafer*» en langue anglaise) découpée dans un lingot monocristallin de matériau semi-conducteur. La plaquette peut également être issue d'un lingot multicristallin ou de type « *monolike* »*.*
- Par « à base de », on entend que le silicium cristallin est le matériau principal et majoritaire composant le substrat.
- Par « cristallin », on entend la forme monocristalline ou la forme multicristalline du silicium, excluant donc le silicium amorphe.
- Par « zone polie », on entend un ensemble de localisations à la surface correspondante du substrat ayant subi un polissage permettant de réduire la rugosité de surface (lissage) et obtenir une surface plane.
- Par « zone texturée », on entend un ensemble de localisations à la surface correspondante du substrat ayant subi une structuration définissant des motifs (classiquement en forme de pyramide inversée) à la surface correspondante du substrat. En d'autres termes, la surface correspondante du substrat est une surface non-plane délimitant un ensemble de reliefs.
- Par « film d'oxyde tunnel », on entend un unique film d'oxyde tunnel ou un empilement comportant une pluralité de films d'oxyde tunnel, l'unique film d'oxyde tunnel ou l'empilement étant suffisamment fin pour permettre la circulation d'un courant électrique en son sein par effet tunnel.
- Par « couche », on entend une couche ou une pluralité de sous-couches de même nature.
- Par « diélectrique », on entend que la couche présente une conductivité électrique à 300 K inférieure à 10⁻⁸ S/cm.
- Par « dopants de type p », on entend des espèces qui, introduites dans une matrice d'un matériau semi-conducteur à base de silicium cristallin, acceptent un électron de la bande de conduction.
- Par « dopants de type n », on entend des espèces qui, introduites dans une matrice d'un matériau semi-conducteur à base de silicium cristallin, donnent un électron à la bande de conduction.
- Par « semi-conductrice », on entend que la région correspondante présente une conductivité électrique à 300 K comprise entre 10⁻⁸ S/cm et 10³ S/cm.

Ainsi, un tel procédé selon l'invention permet d'obtenir localement une structure de type oxyde tunnel/polysilicium sur une zone polie, et non pas sur une zone texturée. Une telle structure est plus performante en termes de passivation de surface du substrat (i.e. une tension de circuit ouvert V_{oc} plus élevée) sur une zone polie que sur une zone texturée. Par conséquent, la passivation est améliorée sous les électrodes (contacts électriques), chacune des première et deuxième couches de polysilicium étant en contact avec une électrode.

Les couches diélectriques sont, quant à elles, formées sur une zone texturée (forte rugosité de surface) de manière à diminuer leur réflexion spéculaire et tendre vers une réflexion diffuse.

Le procédé selon l'invention peut comporter une ou plusieurs des caractéristiques suivantes.

Selon une caractéristique de l'invention, le traitement thermique appliqué lors de l'étape b) est adapté de sorte que :
- la première région semi-conductrice dopée présente une première profondeur comprise entre 30 nm et 200 nm ;
- la deuxième région semi-conductrice dopée présente une deuxième profondeur strictement supérieure à la première profondeur, et inférieure ou égale à 1 µm ;
- la troisième région semi-conductrice dopée présente une troisième profondeur comprise entre 30 nm et 200 nm ;
- la quatrième région semi-conductrice dopée présente une quatrième profondeur strictement supérieure à la troisième profondeur, et inférieure ou égale à 1 µm.

### Définition

Par « profondeur », on entend la dimension du profil des dopants dans la région semi-conductrice suivant la normale aux surfaces du substrat.

Ainsi, un avantage procuré par de telles profondeurs est d'améliorer les performances de passivation des première et seconde surfaces du substrat.

Selon une caractéristique de l'invention, l'étape a) est exécutée de sorte que :
- les dopants de type p comportent des atomes de bore ;
- les dopants de type n comportent des atomes de phosphore ;
et le traitement thermique appliqué lors de l'étape b) est un recuit thermique présentant une valeur de température de recuit comprise entre 900°C et 1000°C.

### Définition

Par « recuit thermique », on entend un traitement thermique comportant :
- une phase de montée graduelle en température (rampe de montée) jusqu'à atteindre une température dite température de recuit,
- une phase de maintien (plateau) à la température de recuit, pendant une durée dite durée de recuit,
- une phase de refroidissement.

Ainsi, un avantage procuré par un tel traitement thermique est d'autoriser une co-diffusion des atomes de bore et des atomes de phosphore lors de l'étape b).

Selon une caractéristique de l'invention, le recuit thermique présente une valeur de durée de recuit comprise entre 10 minutes et 3 heures, de préférence comprise entre 30 minutes et 90 minutes.

Selon une caractéristique de l'invention, l'étape a) est exécutée de sorte que :
- les atomes de bore présentent une proportion atomique dans la première couche diélectrique comprise entre 10% et 50%, de préférence comprise entre 10% et 30% ;
- les atomes de phosphore présentent une proportion massique dans la deuxième couche diélectrique supérieure ou égale à 4%, de préférence comprise entre 10% et 30%.

Selon une caractéristique de l'invention, l'étape a) est exécutée de sorte que :
- la première couche diélectrique est à base d'un oxynitrure de silicium SiOₓN_{y} vérifiant 0≤y<x, de préférence hydrogéné ;
- la deuxième couche diélectrique est à base d'un oxynitrure de silicium SiOₓN_{y} vérifiant 0≤x<y, de préférence hydrogéné.

### Définition

Par « à base de », on entend que l'oxynitrure silicium (nitrure de silicium lorsque x=0, oxyde de silicium lorsque y=0) est le matériau principal et majoritaire composant la couche diélectrique correspondante.

Ainsi, un avantage procuré par de telles couches diélectriques est d'obtenir une passivation satisfaisante des première et seconde surfaces du substrat, plus précisément une passivation de l'interface entre la première surface du substrat et la première couche diélectrique, et une passivation de l'interface entre la seconde surface du substrat et la deuxième couche diélectrique.

Selon une caractéristique de l'invention, l'étape a) est exécutée de sorte que la première couche diélectrique et/ou la deuxième couche diélectrique sont recouvertes d'une couche antireflet, la couche antireflet étant de préférence un oxynitrure de silicium ou un nitrure de silicium.

### Définition

Par « couche antireflet », on entend une unique couche ou empilement de sous-couches qui, de par une épaisseur adaptée, permet de réduire les pertes optiques liées aux réflexions du rayonnement lumineux, et par là-même d'optimiser l'absorption du rayonnement lumineux par le substrat.

Selon une caractéristique de l'invention, l'étape a) est exécutée de sorte que les premier et deuxième films d'oxyde tunnel sont à base d'un oxyde de silicium ou d'un oxyde d'aluminium, et présentent chacun une épaisseur inférieure ou égale à 3 nm, de préférence inférieure ou égale à 2 nm.

### Définitions

- Par « oxyde de silicium », on entend l'oxyde de silicium de formule SiOz (dioxyde de silicium), ou ses dérivés SiOₓ non-stoechiométriques.
- Par « oxyde d'aluminium », on entend l'oxyde d'aluminium de formule Al₂O₃ (alumine) ou ses dérivés AlOₓ non-stoechiométriques.

Un oxyde d'aluminium affecte peu la diffusion des atomes de bore en son sein. En revanche, un oxyde de silicium agit comme une barrière de diffusion aux atomes de bore. On privilégiera donc un oxyde d'aluminium pour les premier et deuxième films d'oxydes tunnel afin d'éviter de dégrader la conductance latérale de la première région semi-conductrice dopée, et de simplifier la mise en oeuvre du procédé en autorisant la formation simultanée des premier et deuxième films d'oxydes tunnel de part et d'autre du substrat, réduisant ainsi le temps d'opération.

Selon une caractéristique de l'invention, l'étape a) est exécutée de sorte que la zone texturée de la première surface du substrat est recouverte d'une couche d'alumine, la couche d'alumine présentant de préférence une épaisseur comprise entre 3 nm et 8 nm.

Ainsi, un avantage procuré est d'améliorer les propriétés de passivation de la zone texturée de la première surface.

Selon une caractéristique de l'invention, l'étape a) est exécutée de sorte que la deuxième couche diélectrique, formée sur la zone texturée de la seconde surface du substrat, est recouverte d'une couche d'alumine, la couche d'alumine présentant de préférence une épaisseur comprise entre 2 nm et 6 nm.

Ainsi, un avantage procuré est de limiter l'exo-diffusion des dopants de type n.

Selon une caractéristique de l'invention, les première et deuxième couches diélectriques sont conservées après l'étape b).

Ainsi, un avantage procuré est un gain de temps d'opération puisqu'il n'est pas nécessaire de retirer ces couches puis de former des couches de passivation dédiées.

Selon une caractéristique de l'invention, l'étape c) comporte les étapes :
c₁) former une pâte de sérigraphie sur les première et deuxième couches de polysilicium, possédant une température de cuisson ;
cz) appliquer un traitement thermique à la structure, à la température de cuisson de la pâte de sérigraphie.

### Définitions

- Par « pâte de sérigraphie », on entend une pâte adaptée pour être imprimée par sérigraphie.
- Par « température de cuisson », on entend :
   (i) soit une température de frittage lorsque la pâte de sérigraphie comporte une matrice minérale (e.g. métallique),
   (ii) soit une température de réticulation lorsque la pâte de sérigraphie comporte une matrice organique à base d'un polymère thermodurcissable avec une charge pouvant être métallique.

Selon une caractéristique de l'invention, l'étape a) comporte les étapes :
a₁) prévoir un substrat à base de silicium cristallin, présentant une première surface et une seconde surface opposée ;
az) polir les première et seconde surfaces du substrat ; puis former les premier et deuxième films d'oxyde tunnel ainsi que les première et deuxième couches de polysilicium ;
a₃) former un masque de gravure sur les première et deuxième couches de polysilicium, délimitant une zone à texturer ;
a₄) texturer les première et seconde surfaces du substrat à travers le masque de gravure de manière à former la zone texturée.

Selon une caractéristique de l'invention, l'étape a₃) comporte les étapes :
a₃₀) former une couche d'un matériau à graver sur les première et deuxième couches de polysilicium ;
a₃₁) former une pâte de sérigraphie structurée sur la couche du matériau à graver en utilisant un écran de sérigraphie de manière à délimiter la zone à texturer, la pâte de sérigraphie étant réalisée dans un matériau autorisant une gravure sélective du matériau à graver.

Selon une caractéristique de l'invention, l'étape c₁) est exécutée avec l'écran de sérigraphie utilisé lors de l'étape a₃₁).

Ainsi, un avantage procuré est d'améliorer la reproductibilité du procédé en n'introduisant pas de déformation variable au cours du temps.

L'invention a également pour objet un procédé de fabrication d'une cellule photovoltaïque, comportant les étapes successives :
a') prévoir une structure comprenant :
   - un substrat à base de silicium cristallin, présentant une première surface et une seconde surface opposée, la première surface comportant une zone polie et une zone texturée, la seconde surface étant polie ;
   - un premier film d'oxyde tunnel, formé sur la zone polie de la première surface du substrat ;
   - un deuxième film d'oxyde tunnel, formé sur la seconde surface polie du substrat ;
   - des première et deuxième couches de polysilicium, formées respectivement sur les premier et deuxième films d'oxyde tunnel ;
   - une première couche diélectrique, comprenant des premiers dopants d'un premier type, formée sur la zone texturée de la première surface du substrat et sur la première couche de polysilicium ;
   - une deuxième couche diélectrique, comprenant des deuxièmes dopants d'un deuxième type opposé au premier type, formée sur la deuxième couche de polysilicium ;
b') appliquer un traitement thermique à la structure adapté pour :
   - diffuser les premiers dopants sous la première surface du substrat, depuis la première couche diélectrique formée sur la première couche de polysilicium, à travers la première couche de polysilicium et le premier film d'oxyde tunnel, de manière à former une première région semi-conductrice dopée ;
   - diffuser les premiers dopants sous la première surface du substrat, depuis la première couche diélectrique formée sur la zone texturée de la première surface du substrat, de manière à former une deuxième région semi-conductrice dopée ;
   - diffuser les deuxièmes dopants sous la seconde surface du substrat, depuis la deuxième couche diélectrique, à travers la deuxième couche de polysilicium et le deuxième film d'oxyde tunnel, de manière à former une troisième région semi-conductrice dopée ;
c') mettre en contact chacune des première et deuxième couches de polysilicium avec une électrode.

Le concept inventif commun réside dans l'obtention locale d'une structure de type oxyde tunnel/polysilicium sur une zone polie, et non pas sur une zone texturée. Une telle structure est plus performante en termes de passivation de surface du substrat (i.e. une tension de circuit ouvert V_{oc} plus élevée) sur une zone polie que sur une zone texturée. Par conséquent, la passivation est améliorée sous les électrodes (contacts électriques), chacune des première et deuxième couches de polysilicium étant en contact avec une électrode.

L'invention a également pour objet une cellule photovoltaïque, comportant :
- un substrat à base de silicium cristallin, présentant une première surface et une seconde surface opposée comportant chacune une zone polie et une zone texturée ;
- des premier et deuxième films d'oxyde tunnel, formés respectivement sur la zone polie des première et seconde surfaces du substrat ;
- des première et deuxième couches de polysilicium, formées respectivement sur les premier et deuxième films d'oxyde tunnel ;
- des première et seconde électrodes, respectivement agencées en contact avec les première et deuxième couches de polysilicium ;
- une première couche diélectrique, comprenant des dopants de type p dans une proportion résiduelle, formée sur la zone texturée de la première surface du substrat ;
- une deuxième couche diélectrique, comprenant des dopants de type n dans une proportion résiduelle, formée sur la zone texturée de la seconde surface du substrat ;
- des première et deuxième régions semi-conductrices dopées de type p, s'étendant sous la première surface du substrat, faisant respectivement face au premier film d'oxyde tunnel et à la première couche diélectrique ;
- des troisième et quatrième régions semi-conductrices dopées de type n, s'étendant sous la seconde surface du substrat, faisant respectivement face au deuxième film d'oxyde tunnel et à la deuxième couche diélectrique.

L'invention a enfin pour objet une cellule photovoltaïque, comportant :
- un substrat à base de silicium cristallin, présentant une première surface et une seconde surface opposée, la première surface comportant une zone polie et une zone texturée, la seconde surface étant polie ;
- un premier film d'oxyde tunnel, formé sur la zone polie de la première surface du substrat ;
- un deuxième film d'oxyde tunnel, formé sur la seconde surface polie du substrat ;
- des première et deuxième couches de polysilicium, formées respectivement sur les premier et deuxième films d'oxyde tunnel ;
- des première et seconde électrodes, respectivement agencées en contact avec les première et deuxième couches de polysilicium ;
- une première couche diélectrique, comprenant des premiers dopants d'un premier type dans une proportion résiduelle, formée sur la zone texturée de la première surface du substrat ;
- une deuxième couche diélectrique, comprenant des deuxièmes dopants d'un deuxième type opposé au premier type dans une proportion résiduelle, formée sur la deuxième couche de polysilicium ;
- des première et deuxième régions semi-conductrices dopées du premier type, s'étendant sous la première surface du substrat, faisant respectivement face au premier film d'oxyde tunnel et à la première couche diélectrique ;
- une troisième région semi-conductrice dopée du deuxième type, s'étendant sous la seconde surface du substrat.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe d'une cellule photovoltaïque selon l'invention, illustrant un premier mode de réalisation.
Figure 2 est une vue schématique en coupe d'une cellule photovoltaïque selon l'invention, illustrant un deuxième mode de réalisation.
Figure 3 est une vue schématique en coupe d'une cellule photovoltaïque selon l'invention, illustrant un troisième mode de réalisation.
Figure 4 est une vue schématique en coupe, à l'échelle agrandie, d'une première face d'une cellule photovoltaïque obtenue par un mode de mise en oeuvre d'un procédé selon l'invention.
Figure 5 est une vue schématique en coupe, à l'échelle agrandie, de la première face d'une cellule photovoltaïque obtenue par un autre mode de mise en oeuvre d'un procédé selon l'invention.
Figure 6 est une vue schématique en coupe, à l'échelle agrandie, d'une seconde face d'une cellule photovoltaïque obtenue par un mode de mise en oeuvre d'un procédé selon l'invention.
Figure 7 est une vue schématique en coupe, à l'échelle agrandie, de la seconde face d'une cellule photovoltaïque obtenue par un autre mode de mise en oeuvre d'un procédé selon l'invention.
Figures 8a à 8j sont des vues schématiques en coupe illustrant des étapes d'un procédé selon l'invention.

Les coupes sont effectuées suivant la normale aux surfaces du substrat.

Il est à noter que les dessins décrits ci-avant sont schématiques, et ne sont pas à l'échelle par souci de lisibilité et pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'une cellule photovoltaïque, comportant les étapes successives :
a) prévoir une structure comprenant :
   - un substrat 1 à base de silicium cristallin, présentant une première surface 10 et une seconde surface 11 opposée comportant chacune une zone polie ZP et une zone texturée ZT;
   - des premier et deuxième films d'oxyde tunnel 2a, 2b, formés respectivement sur la zone polie ZP des première et seconde surfaces 10, 11 du substrat 1 ;
   - des première et deuxième couches de polysilicium 3a, 3b, formées respectivement sur les premier et deuxième films d'oxyde tunnel 2a, 2b ;
   - une première couche diélectrique 4a, comprenant des dopants de type p, formée sur la zone texturée ZT de la première surface 10 du substrat 1 et sur la première couche de polysilicium 3a ;
   - une deuxième couche diélectrique 4b, comprenant des dopants de type n, formée sur la zone texturée ZT de la seconde surface 11 du substrat 1 et sur la deuxième couche de polysilicium 3b ;
b) appliquer un traitement thermique à la structure adapté pour :
   - diffuser les dopants de type p sous la première surface 10 du substrat 1, depuis la première couche diélectrique 4a formée sur la première couche de polysilicium 3a, à travers la première couche de polysilicium 3a et le premier film d'oxyde tunnel 2a, de manière à former une première région semi-conductrice dopée R1 ;
   - diffuser les dopants de type p sous la première surface 10 du substrat 1, depuis la première couche diélectrique 4a formée sur la zone texturée ZT de la première surface 10 du substrat 1, de manière à former une deuxième région semi-conductrice dopée R2 ;
   - diffuser les dopants de type n sous la seconde surface 11 du substrat 1, depuis la deuxième couche diélectrique 4b formée sur la deuxième couche de polysilicium 3b, à travers la deuxième couche de polysilicium 3b et le deuxième film d'oxyde tunnel 2b, de manière à former une troisième région semi-conductrice dopée R3 ;
   - diffuser les dopants de type n sous la seconde surface 11 du substrat 1, depuis la deuxième couche diélectrique 4b formée sur la zone texturée ZT de la seconde surface 11 du substrat 1, de manière à former une quatrième région semi-conductrice dopée R4 ;
c) mettre en contact chacune des première et deuxième couches de polysilicium 3a, 3b avec une électrode E.

### Substrat

Le substrat 1 de la structure prévue lors de l'étape a) est avantageusement dopé de type n, et la première surface 10 du substrat 1 est destinée à être exposée à un rayonnement lumineux de manière à former une architecture à émetteur standard. Les première et deuxième régions semi-conductrices dopées R1, R2 de type p forment l'émetteur. Les troisième et quatrième régions semi-conductrices dopées R3, R4 de type n (même type de dopage que le substrat 1) permettent de créer un champ de surface arrière BSF (« *Back Surface Field* » en langue anglaise).

A titre d'exemple non limitatif, le substrat 1 de la structure prévue lors de l'étape a) peut présenter une épaisseur de l'ordre de 150 µm.

La zone polie ZP de la première surface 10 du substrat 1 correspond à un ensemble de premières localisations à la première surface 10 ayant subi un polissage. La zone texturée ZT de la première surface 10 du substrat 1 correspond à un ensemble de deuxièmes localisations à la première surface 10 ayant subi une structuration définissant des motifs à la première surface 10. Les premières et deuxièmes localisations se succèdent à la première surface 10 en alternance. De la même façon, la zone polie ZP de la seconde surface 11 du substrat 1 correspond à un ensemble de premières localisations à la seconde surface 11 ayant subi un polissage. La zone texturée ZT de la seconde surface 11 du substrat 1 correspond à un ensemble de deuxièmes localisations à la seconde surface 11 ayant subi une structuration définissant des motifs à la seconde surface 11. Les premières et deuxièmes localisations se succèdent à la seconde surface 11 en alternance. La zone polie ZP de la première surface 10 du substrat 1 fait de préférence face à la zone polie ZP de la seconde surface 11 du substrat 1. La zone texturée ZT de la première surface 10 du substrat 1 fait de préférence face à la zone texturée ZT de la seconde surface 11 du substrat 1.

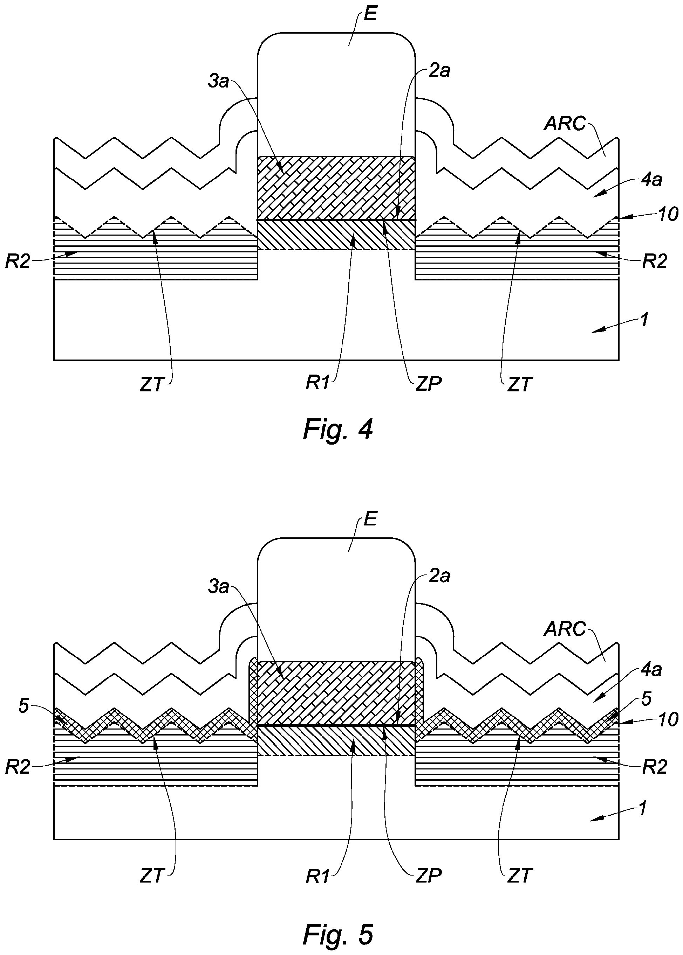

Comme illustré à la figure 5, l'étape a) est avantageusement exécutée de sorte que la zone texturée ZT de la première surface 10 du substrat 1 est recouverte d'une couche d'alumine 5, la couche d'alumine 5 présentant de préférence une épaisseur comprise entre 3 nm et 8 nm.

### Films d'oxyde tunnel

Les premier et deuxième films d'oxyde tunnel 2a, 2b sont avantageusement à base d'un oxyde de silicium ou d'un oxyde d'aluminium. Les premier et deuxième films d'oxyde tunnel 2a, 2b présentent avantageusement chacun une épaisseur inférieure ou égale à 3 nm, de préférence inférieure ou égale à 2 nm.

Les premier et deuxième films d'oxyde tunnel 2a, 2b peuvent être formés respectivement sur la zone polie ZP des première et seconde surfaces 10, 11 du substrat 1 par dépôt de couches atomiques (ALD). Lorsque les premier et deuxième films d'oxyde tunnel 2a, 2b sont à base d'un oxyde de silicium, ceux-ci peuvent être formés par voie thermique, par voie chimique ou par une combinaison des voies thermique et chimique.

### Couches de polysilicium

Les première et deuxième couches de polysilicium 3a, 3b présentent avantageusement une épaisseur comprise entre 30 nm et 200 nm, de préférence comprise entre 70 nm et 100 nm.

Les première et deuxième couches de polysilicium 3a, 3b, sont formées respectivement sur les premier et deuxième films d'oxyde tunnel 2a, 2b avantageusement par un dépôt d'une couche de silicium amorphe (e.g. par LPCVD «*Low Pressure Chemical Vapor Deposition* », ou encore par PECVD «*Plasma-Enhanced Chemical Vapor Deposition* »), suivi d'un recuit permettant de cristalliser la couche de silicium amorphe. Ce recuit peut être exécuté par le traitement thermique appliqué lors de l'étape b).

### Première couche diélectrique

L'étape a) est avantageusement exécutée de sorte que la première couche diélectrique 4a est à base d'un oxynitrure de silicium SiOₓN_{y} vérifiant 0≤y<x, de préférence hydrogéné. L'oxynitrure de silicium de la première couche diélectrique 4a vérifie avantageusement 0,2≤x≤0,5 et 0,05≤y≤0,15 avant l'étape b). La première couche diélectrique 4a présente avantageusement une épaisseur comprise entre 3 nm et 35 nm, de préférence comprise entre 20 nm et 35 nm.

Lorsque les dopants de type p comportent des atomes de bore, les atomes de bore présentent avantageusement une proportion atomique dans la première couche diélectrique 4a comprise entre 10% et 50%, de préférence comprise entre 10% et 30% avant l'étape b). Les atomes de bore présentent avantageusement une proportion atomique dans la première couche diélectrique 4a comprise entre 1% et 10%, de préférence comprise entre 3% et 8% après l'étape b).

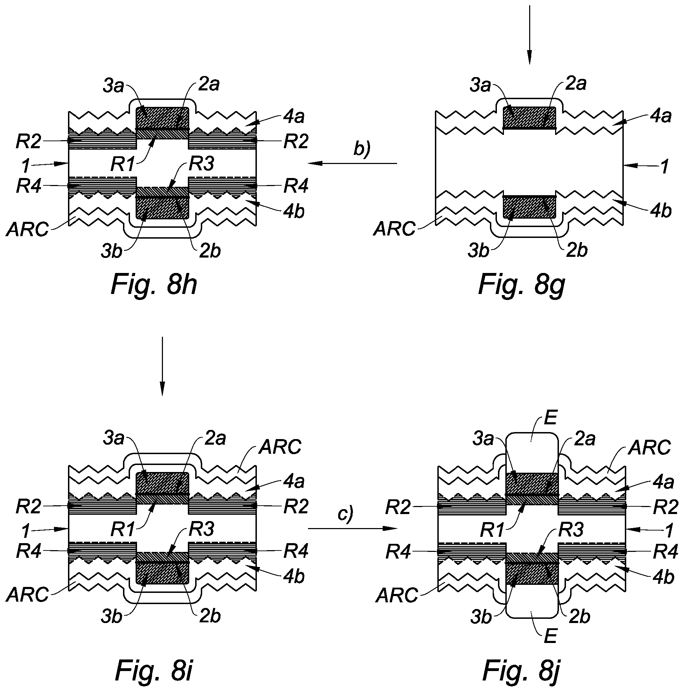

Lorsque la première couche diélectrique 4a est réalisée dans un matériau à base d'un oxynitrure de silicium hydrogéné, cette couche peut être formée (comme illustré à la figure 8g) par un dépôt chimique en phase vapeur (PECVD pour « *Plasma-Enhanced Chemical Vapor Deposition* » en langue anglaise) à partir de gaz réactifs comportant du silane SiH₄ et du protoxyde d'azote NzO ou du NH₃. Les atomes de bore sont avantageusement incorporés à l'oxynitrure de silicium hydrogéné par une injection de diborane B₂H₆ avec les gaz réactifs.

Comme illustré à la figure 8i, la première couche diélectrique 4a peut être recouverte d'une couche antireflet ARC, la couche antireflet ARC étant de préférence un oxynitrure de silicium ou un nitrure de silicium.

La première couche diélectrique 4a est avantageusement conservée après l'étape b).

### Deuxième couche diélectrique

L'étape a) est avantageusement exécutée de sorte que la deuxième couche diélectrique 4b est à base d'un oxynitrure de silicium SiOₓN_{y} vérifiant 0≤x<y, de préférence hydrogéné. L'oxynitrure de silicium de la deuxième couche diélectrique 4b vérifie avantageusement 0<x≤0,05 et 0,30≤y≤0,55 avant et après l'étape b). La deuxième couche diélectrique 4b présente avantageusement une épaisseur comprise entre 10 nm et 40 nm.

Lorsque les dopants de type n comportent des atomes de phosphore, les atomes de phosphore présentent une proportion massique dans la deuxième couche diélectrique 4b supérieure ou égale à 4%, de préférence comprise entre 10% et 30% avant l'étape b). Les atomes de phosphore présentent avantageusement une proportion atomique dans la deuxième couche diélectrique 4b comprise entre 1% et 10%, de préférence comprise entre 1% et 5% après l'étape b).

Lorsque la deuxième couche diélectrique 4b est réalisée dans un matériau à base d'un oxynitrure de silicium hydrogéné, cette couche peut être formée (comme illustré à la figure 8g) par un dépôt chimique en phase vapeur (PECVD pour « *Plasma-Enhanced Chemical Vapor Deposition* » en langue anglaise) à partir de gaz réactifs comportant du silane SiH₄ et du NH₃. Les atomes de phosphore sont avantageusement incorporés à l'oxynitrure de silicium hydrogéné par une injection de phosphine PH₃ avec les gaz réactifs.

Comme illustré à la figure 8i, la deuxième couche diélectrique 4b peut être recouverte d'une couche antireflet ARC, la couche antireflet ARC étant de préférence un oxynitrure de silicium ou un nitrure de silicium.

La deuxième couche diélectrique 4b est avantageusement conservée après l'étape b).

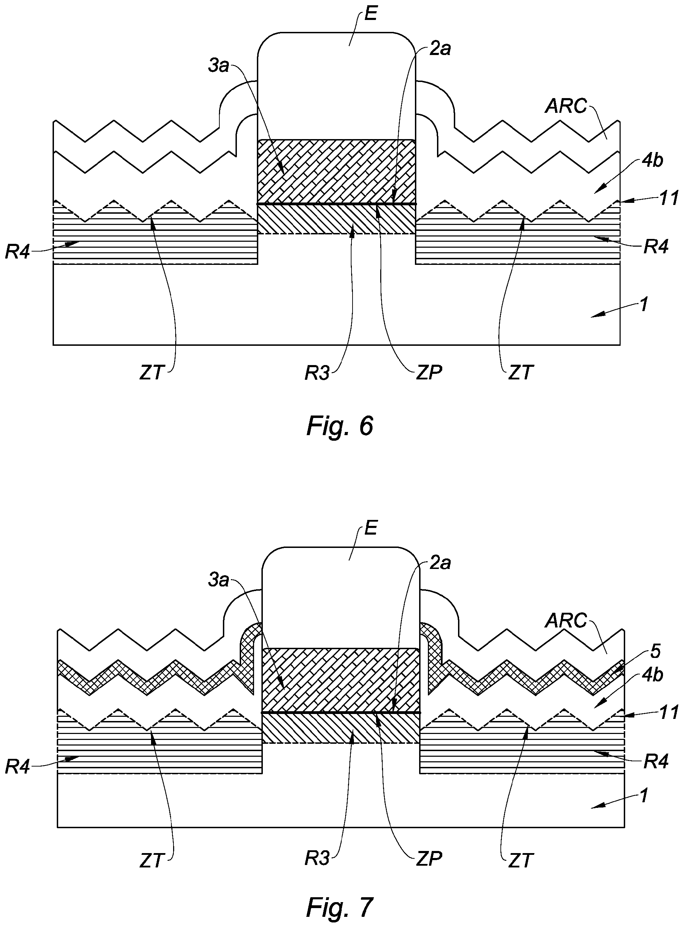

Comme illustré à la figure 7, l'étape a) est avantageusement exécutée de sorte que la deuxième couche diélectrique 4b, formée sur la zone texturée ZT de la seconde surface 11 du substrat 1, est recouverte d'une couche d'alumine 5, la couche d'alumine 5 présentant de préférence une épaisseur comprise entre 2 nm et 6 nm.

### Obtention de la structure prévue lors de l'étape a)

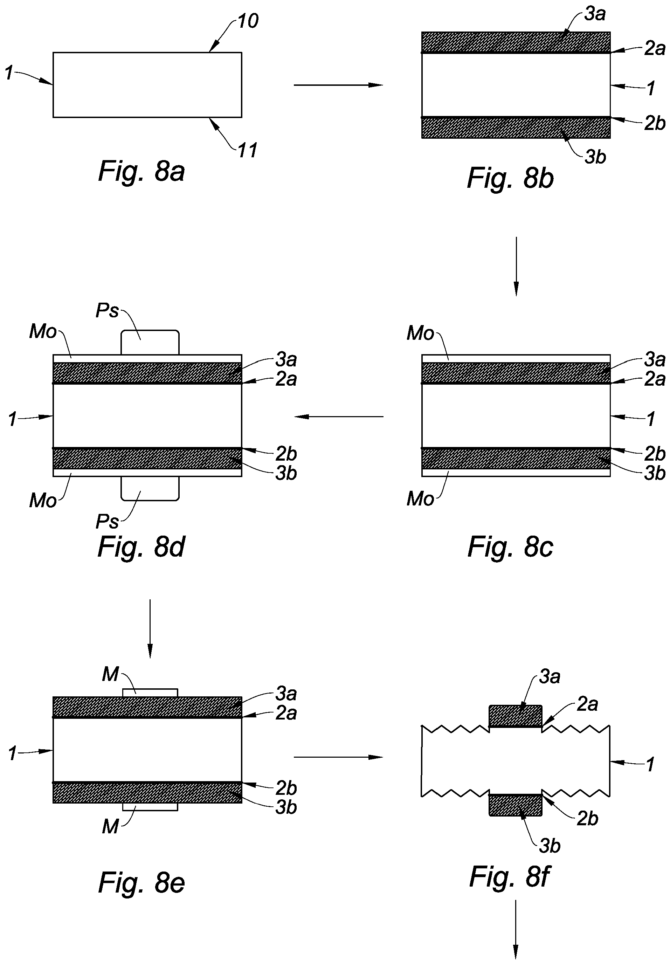

L'étape a) comporte avantageusement les étapes :
a₁) prévoir un substrat 1 à base de silicium cristallin, présentant une première surface 10 et une seconde surface 11 opposée (illustré à la figure 8a) ;
az) polir les première et seconde surfaces 10, 11 du substrat 1 ; puis former les premier et deuxième films d'oxyde tunnel 2a, 2b ainsi que les première et deuxième couches de polysilicium 3a, 3b (illustré à la figure 8b) ;
a₃) former un masque de gravure M sur les première et deuxième couches de polysilicium 3a, 3b , délimitant une zone à texturer ZT (illustré à la figure 8e) ;
a₄) texturer les première et seconde surfaces 10, 11 du substrat 1 à travers le masque de gravure M de manière à former la zone texturée ZT (illustré à la figure 8f).

Le substrat 1 prévu lors de l'étape a₁) peut présenter une épaisseur adaptée de sorte que le substrat 1 obtenu à l'issue de l'étape a₄) présente une épaisseur de l'ordre de 150 µm.

L'étape a₂) peut être exécutée par une attaque chimique à base d'hydroxyde de potassium KOH. La solution d'hydroxyde de potassium KOH utilisée lors de l'étape a₂) présente un pourcentage massique élevé, supérieur ou égal à 20%. L'étape a₂) est avantageusement suivie d'une étape de nettoyage chimique des première et seconde surfaces 10, 11 polies du substrat 1.

L'étape a₃) comporte avantageusement les étapes :
a₃₀) former une couche Mₒ d'un matériau à graver sur les première et deuxième couches de polysilicium 3a, 3b (illustré à la figure 8c) ;
a₃₁) former une pâte de sérigraphie Pₛ structurée sur la couche Mₒ du matériau à graver en utilisant un écran de sérigraphie de manière à délimiter la zone à texturer ZT, la pâte de sérigraphie Pₛ étant réalisée dans un matériau autorisant une gravure sélective du matériau à graver (illustré à la figure 8d). La couche Mₒ du matériau gravé forme le masque de gravure M (masque dur).

L'étape a₃₀) peut être exécutée par LPCVD « *Low Pressure Chemical Vapor Deposition* ». Le matériau à graver de la couche Mₒ formée lors de l'étape a₃₀) peut être un oxyde ou le SiN.

Pour l'étape a₃₁), le matériau dans lequel est réalisée la pâte de sérigraphie Pₛ peut être résistant à l'acide fluorhydrique HF de manière à autoriser une gravure sélective du SiN.

Selon une alternative, l'étape a₃) peut être exécutée à l'aide d'un masque de gravure M réalisé sous la forme d'une pâte de sérigraphie structurée, résistante à l'hydroxyde de potassium KOH, agent chimique pouvant être utilisé lors de l'étape a₄).

En effet, l'étape a₄) est avantageusement exécutée par une attaque chimique à base d'hydroxyde de potassium KOH, de préférence de manière à obtenir des motifs en pyramide inversée agencés pour créer une rugosité de surface. La solution d'hydroxyde de potassium KOH utilisée lors de l'étape a₄) présente un pourcentage massique faible, inférieur à 10%, typiquement de l'ordre de quelques pourcents.

### Traitement thermique de l'étape b)

Comme illustré à la figure 8h, le traitement thermique appliqué lors de l'étape b) est avantageusement adapté de sorte que :
- la première région semi-conductrice dopée R1 présente une première profondeur comprise entre 30 nm et 200 nm ;
- la deuxième région semi-conductrice dopée R2 présente une deuxième profondeur strictement supérieure à la première profondeur, et inférieure ou égale à 1 µm ;
- la troisième région semi-conductrice dopée R3 présente une troisième profondeur comprise entre 30 nm et 200 nm ;
- la quatrième région semi-conductrice dopée R4 présente une quatrième profondeur strictement supérieure à la troisième profondeur, et inférieure ou égale à 1 µm.

Lorsque l'étape a) est exécutée de sorte que :
- les dopants de type p comportent des atomes de bore ;
- les dopants de type n comportent des atomes de phosphore ;
le traitement thermique appliqué lors de l'étape b) est avantageusement un recuit thermique présentant une valeur de température de recuit comprise entre 900°C et 1000°C. Le recuit thermique présente avantageusement une valeur de durée de recuit comprise entre 10 minutes et 3 heures, de préférence comprise entre 30 minutes et 90 minutes.

Le recuit thermique appliqué lors de l'étape b) est un recuit thermique global au sens où il est appliqué à l'ensemble de la structure prévue lors de l'étape a). Il ne s'agit donc pas d'un recuit thermique localisé appliqué sur une partie dudit ensemble, par exemple à l'aide d'un laser. L'étape b) est préférentiellement exécutée dans un four.

Le recuit thermique est avantageusement appliqué lors de l'étape b) sous une atmosphère neutre. L'atmosphère neutre comporte avantageusement au moins un gaz neutre choisi parmi l'argon et l'azote.

### Mise en contact de l'étape c)

L'étape c) comporte avantageusement les étapes :
c₁) former une pâte de sérigraphie Pₛ sur les première et deuxième couches de polysilicium 3a, 3b, possédant une température de cuisson ;
cz) appliquer un traitement thermique à la structure, à la température de cuisson de la pâte de sérigraphie Pₛ.

L'étape c₁) ne nécessite pas une étape préalable consistant à mettre à nu les première et deuxième couches de polysilicium 3a, 3b, la pâte de sérigraphie Pₛ pouvant traverser la structure pour atteindre la couche de polysilicium 3a, 3b correspondante lors de l'étape c₂). L'étape c₁) est avantageusement exécutée avec l'écran de sérigraphie utilisé lors de l'étape a₃₁). On privilégiera une pâte de sérigraphie Pₛ à matrice minérale lors de l'étape c₁) afin d'exécuter un recuit de sérigraphie à haute température (entre 400°C et 900°C) afin d'obtenir un contact électrique de meilleure qualité. La pâte de sérigraphie Pₛ formée lors de l'étape c₁) peut présenter une épaisseur de l'ordre de 10 µm. La pâte de sérigraphie Pₛ formée sur la première couche de polysilicium 3a n'est pas nécessairement identique (en termes de matériau utilisé) à la pâte de sérigraphie Pₛ formée sur la deuxième couche de polysilicium 3b. En d'autres termes, l'étape c₁) peut être exécutée en formant des première et deuxième pâtes de sérigraphie Pₛ respectivement sur les première et deuxième couches de polysilicium 3a, 3b.

Comme illustré à la figure 8j, à l'issue de l'étape c₂), la pâte de sérigraphie Pₛ forme une électrode E.

Bien entendu, l'électrode E en contact avec la première couche de polysilicium 3a et l'électrode E en contact avec la deuxième couche de polysilicium 3b ne constituent pas une électrode commune.

### Cellule photovoltaïque obtenue à l'issue du procédé

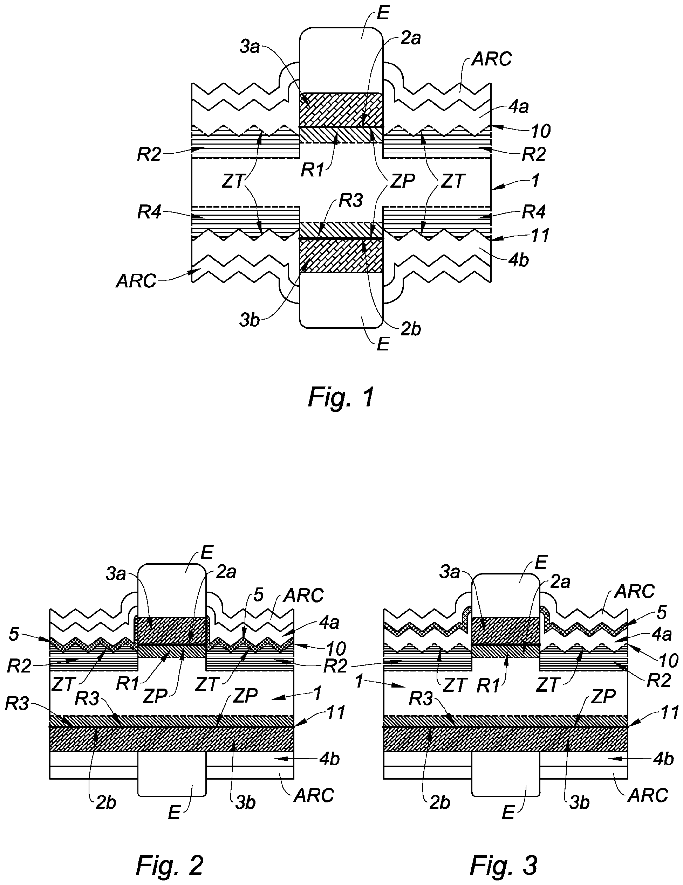

Comme illustré aux figures 1, 4 et 6, un objet de l'invention est une cellule photovoltaïque, comportant :
- un substrat 1 à base de silicium cristallin, présentant une première surface 10 et une seconde surface 11 opposée comportant chacune une zone polie ZP et une zone texturée ZT;
- des premier et deuxième films d'oxyde tunnel 2a, 2b, formés respectivement sur la zone polie ZP des première et seconde surfaces 10, 11 du substrat 1 ;
- des première et deuxième couches de polysilicium 3a, 3b, formées respectivement sur les premier et deuxième films d'oxyde tunnel 2a, 2b ;
- des première et seconde électrodes E, respectivement agencées en contact avec les première et deuxième couches de polysilicium 3a, 3b ;
- une première couche diélectrique 4a, comprenant des dopants de type p dans une proportion résiduelle, formée sur la zone texturée ZT de la première surface 10 du substrat 1 ;
- une deuxième couche diélectrique 4b, comprenant des dopants de type n dans une proportion résiduelle, formée sur la zone texturée ZT de la seconde surface 11 du substrat 1 ;
- des première et deuxième régions semi-conductrices dopées R1, R2 de type p, s'étendant sous la première surface du substrat, faisant respectivement face au premier film d'oxyde tunnel et à la première couche diélectrique ;
- des troisième et quatrième régions semi-conductrices dopées R3, R4 de type n, s'étendant sous la seconde surface 11 du substrat 1, faisant respectivement face au deuxième film d'oxyde tunnel 2b et à la deuxième couche diélectrique 4b.

Une telle cellule photovoltaïque peut être obtenue à l'issue de l'étape c) du procédé.

### Autres architectures de cellules photovoltaïques

Un objet de l'invention est un procédé de fabrication d'une cellule photovoltaïque, comportant les étapes successives :
a') prévoir une structure comprenant :
   - un substrat 1 à base de silicium cristallin, présentant une première surface 10 et une seconde surface 11 opposée, la première surface 10 comportant une zone polie ZP et une zone texturée ZT, la seconde surface 11 étant polie (ZP aux figures 2 et 3) ;
   - un premier film d'oxyde tunnel 2a, formé sur la zone polie ZP de la première surface 10 du substrat 1 ;
   - un deuxième film d'oxyde tunnel 2b, formé sur la seconde surface 11 polie du substrat 1 ;
   - des première et deuxième couches de polysilicium 3a, 3b, formées respectivement sur les premier et deuxième films d'oxyde tunnel 2a, 2b ;
   - une première couche diélectrique 4a, comprenant des premiers dopants d'un premier type, formée sur la zone texturée ZT de la première surface 10 du substrat 1 et sur la première couche de polysilicium 3a ;
   - une deuxième couche diélectrique 4b, comprenant des deuxièmes dopants d'un deuxième type opposé au premier type, formée sur la deuxième couche de polysilicium 3b ;
b') appliquer un traitement thermique à la structure adapté pour :
   - diffuser les premiers dopants sous la première surface 10 du substrat 1, depuis la première couche diélectrique 4a formée sur la première couche de polysilicium 3a, à travers la première couche de polysilicium 3a et le premier film d'oxyde tunnel 2a, de manière à former une première région semi-conductrice dopée R1 ;
   - diffuser les premiers dopants sous la première surface 10 du substrat 1, depuis la première couche diélectrique 4a formée sur la zone texturée ZT de la première surface 10 du substrat 1, de manière à former une deuxième région semi-conductrice dopée R2 ;
   - diffuser les deuxièmes dopants sous la seconde surface 11 du substrat 1, depuis la deuxième couche diélectrique 4b, à travers la deuxième couche de polysilicium 3b et le deuxième film d'oxyde tunnel 2b, de manière à former une troisième région semi-conductrice dopée R3 ;
c') mettre en contact chacune des première et deuxième couches de polysilicium 3a, 3b avec une électrode E.

Comme illustré aux figures 2 et 3, un objet de l'invention est une cellule photovoltaïque, comportant :
- un substrat 1 à base de silicium cristallin, présentant une première surface 10 et une seconde surface 11 opposée, la première surface 10 comportant une zone polie ZP et une zone texturée ZT, la seconde surface 11 étant polie (ZP aux figures 2 et 3) ;
- un premier film d'oxyde tunnel 2a, formé sur la zone polie ZP de la première surface 10 du substrat 1 ;
- un deuxième film d'oxyde tunnel 2b, formé sur la seconde surface 11 polie du substrat 1 ;
- des première et deuxième couches de polysilicium 3a, 3b, formées respectivement sur les premier et deuxième films d'oxyde tunnel 2a, 2b ;
- des première et seconde électrodes E, respectivement agencées en contact avec les première et deuxième couches de polysilicium 3a, 3b ;
- une première couche diélectrique 4a, comprenant des premiers dopants d'un premier type dans une proportion résiduelle, formée sur la zone texturée ZT de la première surface 10 du substrat 1 ;
- une deuxième couche diélectrique 4b, comprenant des deuxièmes dopants d'un deuxième type opposé au premier type dans une proportion résiduelle, formée sur la deuxième couche de polysilicium 3b ;
- des première et deuxième régions semi-conductrices dopées R1, R2 du premier type, s'étendant sous la première surface 10 du substrat 1, faisant respectivement face au premier film d'oxyde tunnel 2a et à la première couche diélectrique 4a ;
- une troisième région semi-conductrice dopée R3 du deuxième type, s'étendant sous la seconde surface 11 du substrat 1.

Une telle cellule photovoltaïque peut être obtenue à l'issue de l'étape c') du procédé.

Pour la cellule photovoltaïque illustrée à la figure 2, les premiers dopants sont des dopants de type p. Comme illustré à la figure 2, l'étape a') est avantageusement exécutée de sorte que la zone texturée ZT de la première surface 10 du substrat 1 est recouverte d'une couche d'alumine 5, la couche d'alumine 5 présentant de préférence une épaisseur comprise entre 3 nm et 8 nm.

Pour la cellule photovoltaïque illustrée à la figure 3, les premiers dopants sont des dopants de type n. Comme illustré à la figure 3, l'étape a') est avantageusement exécutée de sorte que la première couche diélectrique 4a, formée sur la zone texturée ZT de la première surface 10 du substrat 1, est recouverte d'une couche d'alumine 5, la couche d'alumine 5 présentant de préférence une épaisseur comprise entre 2 nm et 6 nm.

L'invention ne se limite pas aux modes de réalisation exposés. L'homme du métier est mis à même de considérer leurs combinaisons techniquement opérantes, et de leur substituer des équivalents.

## Revendications

1. Procédé de fabrication d'une cellule photovoltaïque, comportant les étapes successives :
a) prévoir une structure comprenant :
- un substrat (1) à base de silicium cristallin, présentant une première surface (10) et une seconde surface (11) opposée comportant chacune une zone polie (ZP) et une zone texturée (ZT) ;
- des premier et deuxième films d'oxyde tunnel (2a, 2b), formés respectivement sur la zone polie (ZP) des première et seconde surfaces (10, 11) du substrat (1) ;
- des première et deuxième couches de polysilicium (3a, 3b), formées respectivement sur les premier et deuxième films d'oxyde tunnel (2a, 2b) ;
- une première couche diélectrique (4a), comprenant des dopants de type p, formée sur la zone texturée (ZT) de la première surface (10) du substrat (1) et sur la première couche de polysilicium (3a) ;
- une deuxième couche diélectrique (4b), comprenant des dopants de type n, formée sur la zone texturée (ZT) de la seconde surface (11) du substrat (1) et sur la deuxième couche de polysilicium (3b) ;
b) appliquer un traitement thermique à la structure adapté pour :
- diffuser les dopants de type p sous la première surface (10) du substrat (1), depuis la première couche diélectrique (4a) formée sur la première couche de polysilicium (3a), à travers la première couche de polysilicium (3a) et le premier film d'oxyde tunnel (2a), de manière à former une première région semi-conductrice dopée (R1) ;
- diffuser les dopants de type p sous la première surface (10) du substrat (1), depuis la première couche diélectrique (4a) formée sur la zone texturée (ZT) de la première surface (10) du substrat (1), de manière à former une deuxième région semi-conductrice dopée (R2) ;
- diffuser les dopants de type n sous la seconde surface (11) du substrat (1), depuis la deuxième couche diélectrique (4b) formée sur la deuxième couche de polysilicium (3b), à travers la deuxième couche de polysilicium (3b) et le deuxième film d'oxyde tunnel (2b), de manière à former une troisième région semi-conductrice dopée (R3) ;
- diffuser les dopants de type n sous la seconde surface (11) du substrat (1), depuis la deuxième couche diélectrique (4b) formée sur la zone texturée (ZT) de la seconde surface (11) du substrat (1), de manière à former une quatrième région semi-conductrice dopée (R4) ;
c) mettre en contact chacune des première et deuxième couches de polysilicium (3a, 3b) avec une électrode (E).

2. Procédé selon la revendication 1, dans lequel le traitement thermique appliqué lors de l'étape b) est adapté de sorte que :
- la première région semi-conductrice dopée (R1) présente une première profondeur comprise entre 30 nm et 200 nm ;
- la deuxième région semi-conductrice dopée (R2) présente une deuxième profondeur strictement supérieure à la première profondeur, et inférieure ou égale à 1 µm ;
- la troisième région semi-conductrice dopée (R3) présente une troisième profondeur comprise entre 30 nm et 200 nm ;
- la quatrième région semi-conductrice dopée (R4) présente une quatrième profondeur strictement supérieure à la troisième profondeur, et inférieure ou égale à 1 µm.

3. Procédé selon la revendication 1 ou 2, dans lequel l'étape a) est exécutée de sorte que :
- les dopants de type p comportent des atomes de bore ;
- les dopants de type n comportent des atomes de phosphore ;
et le traitement thermique appliqué lors de l'étape b) est un recuit thermique présentant une valeur de température de recuit comprise entre 900°C et 1000°C.

4. Procédé selon la revendication 3, dans lequel le recuit thermique présente une valeur de durée de recuit comprise entre 10 minutes et 3 heures, de préférence comprise entre 30 minutes et 90 minutes.

5. Procédé selon la revendication 3 ou 4, dans lequel l'étape a) est exécutée de sorte que :
- les atomes de bore présentent une proportion atomique dans la première couche diélectrique comprise entre 10% et 50%, de préférence comprise entre 10% et 30% ;
- les atomes de phosphore présentent une proportion massique dans la deuxième couche diélectrique supérieure ou égale à 4%, de préférence comprise entre 10% et 30%.

6. Procédé selon l'une des revendications 1 à 5, dans lequel l'étape a) est exécutée de sorte que :
- la première couche diélectrique (4a) est à base d'un oxynitrure de silicium SiOₓN_{y} vérifiant 0≤y<x, de préférence hydrogéné ;
- la deuxième couche diélectrique (4b) est à base d'un oxynitrure de silicium SiOₓN_{y} vérifiant 0≤x<y, de préférence hydrogéné ;
- les premier et deuxième films d'oxyde tunnel (2a, 2b) sont à base d'un oxyde de silicium ou d'un oxyde d'aluminium, et présentent chacun une épaisseur inférieure ou égale à 3 nm, de préférence inférieure ou égale à 2 nm.

7. Procédé selon l'une des revendications 1 à 6, dans lequel l'étape a) est exécutée de sorte que la première couche diélectrique (4a) et/ou la deuxième couche diélectrique (4b) sont recouvertes d'une couche antireflet (ARC), la couche antireflet (ARC) étant de préférence un oxynitrure de silicium ou un nitrure de silicium.

8. Procédé selon l'une des revendications 1 à 7, dans lequel l'étape a) est exécutée de sorte que la zone texturée (ZT) de la première surface (10) du substrat (1) est recouverte d'une couche d'alumine (5), la couche d'alumine (5) présentant de préférence une épaisseur comprise entre 3 nm et 8 nm.

9. Procédé selon l'une des revendications 1 à 8, dans lequel l'étape a) est exécutée de sorte que la deuxième couche diélectrique (4b), formée sur la zone texturée (ZT) de la seconde surface (11) du substrat (1), est recouverte d'une couche d'alumine (5), la couche d'alumine (5) présentant de préférence une épaisseur comprise entre 2 nm et 6 nm.

10. Procédé selon l'une des revendications 1 à 9, dans lequel les première et deuxième couches diélectriques (4a, 4b) sont conservées après l'étape b).

11. Procédé selon l'une des revendications 1 à 10, dans lequel l'étape c) comporte les étapes :
c₁) former une pâte de sérigraphie (Pₛ) sur les première et deuxième couches de polysilicium (3a, 3b), possédant une température de cuisson ;
c₂) appliquer un traitement thermique à la structure, à la température de cuisson de la pâte de sérigraphie (Pₛ).

12. Procédé selon l'une des revendications 1 à 11, dans lequel l'étape a) comporte les étapes :
a₁) prévoir un substrat (1) à base de silicium cristallin, présentant une première surface (10) et une seconde surface (11) opposée ;
a₂) polir les première et seconde surfaces (10, 11) du substrat (1) ; puis former les premier et deuxième films d'oxyde tunnel (2a, 2b) ainsi que les première et deuxième couches de polysilicium (3a, 3b) ;
a₃) former un masque de gravure (M) sur les première et deuxième couches de polysilicium (3a, 3b), délimitant une zone à texturer (ZT) ;
a₄) texturer les première et seconde surfaces (10, 11) du substrat (1) à travers le masque de gravure (M) de manière à former la zone texturée (Z1).

13. Procédé de fabrication d'une cellule photovoltaïque, comportant les étapes successives :
a') prévoir une structure comprenant :
- un substrat (1) à base de silicium cristallin, présentant une première surface (10) et une seconde surface (11) opposée, la première surface (10) comportant une zone polie (ZP) et une zone texturée (ZT), la seconde surface (11) étant polie ;
- un premier film d'oxyde tunnel (2a), formé sur la zone polie (ZP) de la première surface (10) du substrat (1) ;
- un deuxième film d'oxyde tunnel (2b), formé sur la seconde surface (11) polie du substrat (1) ;
- des première et deuxième couches de polysilicium (3a, 3b), formées respectivement sur les premier et deuxième films d'oxyde tunnel (2a, 2b) ;
- une première couche diélectrique (4a), comprenant des premiers dopants d'un premier type, formée sur la zone texturée (ZT) de la première surface (10) du substrat (1) et sur la première couche de polysilicium (3a) ;
- une deuxième couche diélectrique (4b), comprenant des deuxièmes dopants d'un deuxième type opposé au premier type, formée sur la deuxième couche de polysilicium (3b) ;
b') appliquer un traitement thermique à la structure adapté pour :
- diffuser les premiers dopants sous la première surface (10) du substrat (1), depuis la première couche diélectrique (4a) formée sur la première couche de polysilicium (3a), à travers la première couche de polysilicium (3a) et le premier film d'oxyde tunnel (2a), de manière à former une première région semi-conductrice dopée (R1) ;
- diffuser les premiers dopants sous la première surface (10) du substrat (1), depuis la première couche diélectrique (4a) formée sur la zone texturée (ZT) de la première surface (10) du substrat (1), de manière à former une deuxième région semi-conductrice dopée (R2) ;
- diffuser les deuxièmes dopants sous la seconde surface (11) du substrat (1), depuis la deuxième couche diélectrique (4b), à travers la deuxième couche de polysilicium (3b) et le deuxième film d'oxyde tunnel (2b), de manière à former une troisième région semi-conductrice dopée (R3) ;
c') mettre en contact chacune des première et deuxième couches de polysilicium (3a, 3b) avec une électrode (E).

14. Cellule photovoltaïque, comportant :
- un substrat (1) à base de silicium cristallin, présentant une première surface (10) et une seconde surface (11) opposée comportant chacune une zone polie (ZP) et une zone texturée (ZT) ;
- des premier et deuxième films d'oxyde tunnel (2a, 2b), formés respectivement sur la zone polie (ZP) des première et seconde surfaces (10, 11) du substrat (1) ;
- des première et deuxième couches de polysilicium (3a, 3b), formées respectivement sur les premier et deuxième films d'oxyde tunnel (2a, 2b) ;
- des première et seconde électrodes (E), respectivement agencées en contact avec les première et deuxième couches de polysilicium (3a, 3b) ;
- une première couche diélectrique (4a), comprenant des dopants de type p dans une proportion résiduelle, formée sur la zone texturée (ZT) de la première surface (10) du substrat (1) ;
- une deuxième couche diélectrique (4b), comprenant des dopants de type n dans une proportion résiduelle, formée sur la zone texturée (ZT) de la seconde surface (11) du substrat (1) ;
- des première et deuxième régions semi-conductrices dopées (R1, R2) de type p, s'étendant sous la première surface (10) du substrat (1), faisant respectivement face au premier film d'oxyde tunnel (2a) et à la première couche diélectrique (4a) ;
- des troisième et quatrième régions semi-conductrices (R3, R4) dopées de type n, s'étendant sous la seconde surface (11) du substrat (1), faisant respectivement face au deuxième film d'oxyde tunnel (2b) et à la deuxième couche diélectrique (4b).

15. Cellule photovoltaïque, comportant :
- un substrat (1) à base de silicium cristallin, présentant une première surface (10) et une seconde surface (11) opposée, la première surface (10) comportant une zone polie (ZP) et une zone texturée (ZT), la seconde surface (11) étant polie ;
- un premier film d'oxyde tunnel (2a), formé sur la zone polie (ZP) de la première surface (10) du substrat (1) ;
- un deuxième film d'oxyde tunnel (2b), formé sur la seconde surface (11) polie du substrat (1) ;
- des première et deuxième couches de polysilicium (3a, 3b), formées respectivement sur les premier et deuxième films d'oxyde tunnel (2a, 2b) ;
- des première et seconde électrodes (E), respectivement agencées en contact avec les première et deuxième couches de polysilicium (3a, 3b) ;
- une première couche diélectrique (4a), comprenant des premiers dopants d'un premier type dans une proportion résiduelle, formée sur la zone texturée (ZT) de la première surface (10) du substrat (1) ;
- une deuxième couche diélectrique (4b), comprenant des deuxièmes dopants d'un deuxième type opposé au premier type dans une proportion résiduelle, formée sur la deuxième couche de polysilicium (3b) ;
- des première et deuxième régions semi-conductrices dopées (R1, R2) du premier type, s'étendant sous la première surface (10) du substrat (1), faisant respectivement face au premier film d'oxyde tunnel (2a) et à la première couche diélectrique (4a) ;
- une troisième région semi-conductrice dopée (R3) du deuxième type, s'étendant sous la seconde surface (11) du substrat (1).

## Patentansprüche

1. Verfahren zur Herstellung einer Photovoltaikzelle, umfassend die aufeinander folgenden Schritte:
a) Bereitstellen einer Struktur, umfassend:
- ein Substrat (1) auf Basis von kristallinem Silicium, das eine erste Oberfläche (10) und eine entgegengesetzte zweite Oberfläche (11) aufweist, die jeweils einen polierten Bereich (ZP) und einen texturierten Bereich (ZT) umfassen;
- erste und zweite Tunneloxidfilme (2a, 2b), die auf dem polierten Bereich (ZP) der ersten beziehungsweise zweiten Oberflächen (10, 11) des Substrats (1) gebildet sind;
- erste und zweite Polysiliciumschichten (3a, 3b), die auf den ersten beziehungsweise zweiten Tunneloxidfilmen (2a, 2b) gebildet sind;
- eine erste dielektrische Schicht (4a), p-Typ-Dotierungsstoffe umfassend, die auf dem texturierten Bereich (ZT) der ersten Oberfläche (10) des Substrats (1) und auf der ersten Polysiliciumschicht (3a) gebildet ist;
- eine zweite dielektrische Schicht (4b), n-Typ-Dotierungsstoffe umfassend, die auf dem texturierten Bereich (ZT) der zweiten Oberfläche (11) des Substrats (1) und auf der zweiten Polysiliciumschicht (3b) gebildet ist;
b) Anwenden einer thermischen Behandlung auf die Struktur, die dazu geeignet ist:
- die p-Typ-Dotierungsstoffe unter die erste Oberfläche (10) des Substrats (1), von der ersten dielektrischen Schicht (4a) aus, die auf der ersten Polysiliciumschicht (3a) gebildet ist, durch die erste Polysiliciumschicht (3a) und den ersten Tunneloxidfilm (2a) hindurch, zu diffundieren, so dass eine erste dotierte halbleitende Region (R1) gebildet wird;
- die p-Typ-Dotierungsstoffe unter die erste Oberfläche (10) des Substrats (1), von der ersten dielektrischen Schicht (4a) aus, die auf dem texturierten Bereich (ZT) der ersten Oberfläche (10) des Substrats (1) gebildet ist, zu diffundieren, so dass eine zweite dotierte halbleitende Region (R2) gebildet wird;
- die n-Typ-Dotierungsstoffe unter die zweite Oberfläche (11) des Substrats (1), von der zweiten dielektrischen Schicht (4b) aus, die auf der zweiten Polysiliciumschicht (3b) gebildet ist, durch die zweite Polysiliciumschicht (3b) und den zweiten Tunneloxidfilm (2b) hindurch, zu diffundieren, so dass eine dritte dotierte halbleitende Region (R3) gebildet wird;
- die n-Typ-Dotierungsstoffe unter die zweite Oberfläche (11) des Substrats (1), von der zweiten dielektrischen Schicht (4b) aus, die auf dem texturierten Bereich (ZT) der zweiten Oberfläche (11) des Substrats (1) gebildet ist, zu diffundieren, so dass eine vierte dotierte halbleitende Region (R4) gebildet wird;
c) Inkontaktbringen jeder der ersten und zweiten Polysiliciumschichten (3a, 3b) mit einer Elektrode (E).

2. Verfahren nach Anspruch 1, wobei die beim Schritt b) angewandte thermische Behandlung so angepasst ist, dass:
- die erste dotierte halbleitende Region (R1) eine erste Tiefe zwischen 30 nm und 200 nm aufweist;
- die zweite dotierte halbleitende Region (R2) eine zweite Tiefe aufweist, die strikt größer als die erste Tiefe ist und kleiner als oder gleich 1 µm ist;
- die dritte dotierte halbleitende Region (R3) eine dritte Tiefe zwischen 30 nm und 200 nm aufweist;
- die vierte dotierte halbleitende Region (R4) eine vierte Tiefe aufweist, die strikt größer als die dritte Tiefe ist und kleiner als oder gleich 1 µm ist.

3. Verfahren nach Anspruch 1 oder 2, wobei der Schritt a) so ausgeführt wird, dass:
- die p-Typ-Dotierungsstoffe Boratome umfassen;
- die n-Typ-Dotierungsstoffe Phosphoratome umfassen;
und die beim Schritt b) angewandte thermische Behandlung ein thermisches Glühen ist, das einen Glühtemperaturwert zwischen 900 °C und 1000 °C aufweist.

4. Verfahren nach Anspruch 3, wobei das thermische Glühen einen Glühdauerwert zwischen 10 Minuten und 3 Stunden, bevorzugt zwischen 30 Minuten und 90 Minuten aufweist.

5. Verfahren nach Anspruch 3 oder 4, wobei der Schritt a) so ausgeführt wird, dass:
- die Boratome ein Atomverhältnis in der ersten dielektrischen Schicht zwischen 10 % und 50 %, bevorzugt zwischen 10 % und 30 % aufweisen.
- die Phosphoratome ein Massenverhältnis in der zweiten dielektrischen Schicht größer als oder gleich 4 %, bevorzugt zwischen 10 % und 30 % aufweisen.

6. Verfahren nach einem der Ansprüche 1 bis 5, wobei der Schritt a) so ausgeführt wird, dass:
- die erste dielektrische Schicht (4a) auf Basis eines, bevorzugt hydrierten, Siliciumoxinitrids SiOₓN_{y} ist, das die Bedingung 0≤y<x erfüllt;
- die zweite dielektrische Schicht (4b) auf Basis eines, bevorzugt hydrierten, Siliciumoxinitrids SiOₓN_{y} ist, das die Bedingung 0≤x<y erfüllt;
- die ersten und zweiten Tunneloxidfilme (2a, 2b) auf Basis eines Siliciumoxids oder eines Aluminiumoxids sind und jeweils eine Dicke kleiner als oder gleich 3 nm, bevorzugt kleiner als oder gleich 2 nm aufweisen.

7. Verfahren nach einem der Ansprüche 1 bis 6, wobei der Schritt a) so ausgeführt wird, dass die erste dielektrische Schicht (4a) und/oder die zweite dielektrische Schicht (4b) mit einer Antireflexschicht (ARC) überzogen sind, wobei die Antireflexschicht (ARC) bevorzugt ein Siliciumoxinitrid oder ein Siliciumnitrid ist.

8. Verfahren nach einem der Ansprüche 1 bis 7, wobei der Schritt a) so ausgeführt wird, dass der texturierte Bereich (ZT) der ersten Oberfläche (10) des Substrats (1) mit einer Tonerdeschicht (5) überzogen ist, wobei die Tonerdeschicht (5) bevorzugt eine Dicke zwischen 3 nm und 8 nm aufweist.

9. Verfahren nach einem der Ansprüche 1 bis 8, wobei der Schritt a) so ausgeführt wird, dass die zweite dielektrische Schicht (4b), die auf dem texturierten Bereich (ZT) der zweiten Oberfläche (11) des Substrats (1) gebildet ist, mit einer Tonerdeschicht (5) überzogen ist, wobei die Tonerdeschicht (5) bevorzugt eine Dicke zwischen 2 nm und 6 nm aufweist.

10. Verfahren nach einem der Ansprüche 1 bis 9, wobei die ersten und zweiten dielektrischen Schichten (4a, 4b) nach dem Schritt b) beibehalten werden.

11. Verfahren nach einem der Ansprüche 1 bis 10, wobei der Schritt c) die folgenden Schritte umfasst:
c₁) Bilden einer Siebdruckpaste (Pₛ) auf den ersten und zweiten Polysiliciumschichten (3a, 3b), die eine Brenntemperatur besitzt;
c₂) Anwenden einer thermischen Behandlung auf die Struktur mit der Brenntemperatur der Siebdruckpaste (Pₛ).

12. Verfahren nach einem der Ansprüche 1 bis 11, wobei der Schritt a) die folgenden Schritte umfasst:
a₁) Bereitstellen eines Substrats (1) auf Basis von kristallinem Silicium, das eine erste Oberfläche (10) und eine entgegengesetzte zweite Oberfläche (11) aufweist;
a₂) Polieren der ersten und zweiten Oberflächen (10, 11) des Substrats (1); dann Bilden der ersten und zweiten Tunneloxidfilme (2a, 2b) sowie der ersten und zweiten Polysiliciumschichten (3a, 3b);
a₃) Bilden einer Ätzmaske (M) auf den ersten und zweiten Polysiliciumschichten (3a, 3b), die einen zu texturierenden Bereich (ZT) begrenzt;
a₄) Texturieren der ersten und zweiten Oberflächen (10, 11) des Substrats (1) durch die Ätzmaske (M) hindurch, so dass der texturierte Bereich (ZT) gebildet wird.

13. Verfahren zur Herstellung einer Photovoltaikzelle, umfassend die aufeinander folgenden Schritte:
a') Bereitstellen einer Struktur, umfassend:
- ein Substrat (1) auf Basis von kristallinem Silicium, das eine erste Oberfläche (10) und eine entgegengesetzte zweite Oberfläche (11) aufweist, wobei die erste Oberfläche (10) einen polierten Bereich (ZP) und einen texturierten Bereich (ZT) umfasst, wobei die zweite Oberfläche (11) poliert ist;
- einen ersten Tunneloxidfilm (2a), der auf dem polierten Bereich (ZP) der ersten Oberfläche (10) des Substrats (1) gebildet ist;
- einen zweiten Tunneloxidfilm (2b), der auf der polierten zweiten Oberfläche (11) des Substrats (1) gebildet ist;
- erste und zweite Polysiliciumschichten (3a, 3b), die auf den ersten beziehungsweise zweiten Tunneloxidfilmen (2a, 2b) gebildet sind;
- eine erste dielektrische Schicht (4a), erste Dotierungsstoffe eines ersten Typs umfassend, die auf dem texturierten Bereich (ZT) der ersten Oberfläche (10) des Substrats (1) und auf der ersten Polysiliciumschicht (3a) gebildet ist;
- eine zweite dielektrische Schicht (4b), zweite Dotierungsstoffe eines zweiten Typs, der zu dem ersten Typ entgegengesetzt ist, umfassend, die auf der zweiten Polysiliciumschicht (3b) gebildet ist;
b') Anwenden einer thermischen Behandlung auf die Struktur, die dazu geeignet ist:
- die ersten Dotierungsstoffe unter die erste Oberfläche (10) des Substrats (1), von der ersten dielektrischen Schicht (4a) aus, die auf der ersten Polysiliciumschicht (3a) gebildet ist, durch die erste Polysiliciumschicht (3a) und den ersten Tunneloxidfilm (2a) hindurch, zu diffundieren, so dass eine erste dotierte halbleitende Region (R1) gebildet wird;
- die ersten Dotierungsstoffe unter die erste Oberfläche (10) des Substrats (1), von der ersten dielektrischen Schicht (4a) aus, die auf dem texturierten Bereich (ZT) der ersten Oberfläche (10) des Substrats (1) gebildet ist, zu diffundieren, so dass eine zweite dotierte halbleitende Region (R2) gebildet wird;
- die zweiten Dotierungsstoffe unter die zweite Oberfläche (11) des Substrats (1), von der zweiten dielektrischen Schicht (4b) aus, durch die zweite Polysiliciumschicht (3b) und den zweiten Tunneloxidfilm (2b) hindurch, zu diffundieren, so dass eine dritte dotierte halbleitende Region (R3) gebildet wird;
c') Inkontaktbringen jeder der ersten und zweiten Polysiliciumschichten (3a, 3b) mit einer Elektrode (E).

14. Photovoltaikzelle, umfassend:
- ein Substrat (1) auf Basis von kristallinem Silicium, das eine erste Oberfläche (10) und eine entgegengesetzte zweite Oberfläche (11) aufweist, die jeweils einen polierten Bereich (ZP) und einen texturierten Bereich (ZT) umfassen;
- erste und zweite Tunneloxidfilme (2a, 2b), die auf dem polierten Bereich (ZP) der ersten beziehungsweise zweiten Oberflächen (10, 11) des Substrats (1) gebildet sind;
- erste und zweite Polysiliciumschichten (3a, 3b), die auf den ersten beziehungsweise zweiten Tunneloxidfilmen (2a, 2b) gebildet sind;
- erste und zweite Elektroden (E), die in Kontakt mit den ersten beziehungsweise zweiten Polysiliciumschichten (3a, 3b) angeordnet sind;
- eine erste dielektrische Schicht (4a), p-Typ-Dotierungsstoffe in einem Restverhältnis umfassend, die auf dem texturierten Bereich (ZT) der ersten Oberfläche (10) des Substrats (1) gebildet ist;
- eine zweite dielektrische Schicht (4b), n-Typ-Dotierungsstoffe in einem Restverhältnis umfassend, die auf dem texturierten Bereich (ZT) der zweiten Oberfläche (11) des Substrats (1) gebildet ist;
- erste und zweite p-Typ-dotierte halbleitende Regionen (R1, R2), die sich unter der ersten Oberfläche (10) des Substrat (1) erstrecken, wobei sie dem ersten Tunneloxidfilm (2a) beziehungsweise der ersten dielektrischen Schicht (4a) gegenüberliegen;
- dritte und vierte n-Typ-dotierte halbleitende Regionen (R3, R4), die sich unter der zweiten Oberfläche (11) des Substrat (1) erstrecken, wobei sie dem zweiten Tunneloxidfilm (2b) beziehungsweise der zweiten dielektrischen Schicht (4b) gegenüberliegen.

15. Photovoltaikzelle, umfassend:
- ein Substrat (1) auf Basis von kristallinem Silicium, das eine erste Oberfläche (10) und eine entgegengesetzte zweite Oberfläche (11) aufweist, wobei die erste Oberfläche (10) einen polierten Bereich (ZP) und einen texturierten Bereich (ZT) umfasst, wobei die zweite Oberfläche (11) poliert ist;
- einen ersten Tunneloxidfilm (2a), der auf dem polierten Bereich (ZP) der ersten Oberfläche (10) des Substrats (1) gebildet ist;
- einen zweiten Tunneloxidfilm (2b), der auf der polierten zweiten Oberfläche (11) des Substrats (1) gebildet ist;
- erste und zweite Polysiliciumschichten (3a, 3b), die auf den ersten beziehungsweise zweiten Tunneloxidfilmen (2a, 2b) gebildet sind;
- erste und zweite Elektroden (E), die in Kontakt mit den ersten beziehungsweise zweiten Polysiliciumschichten (3a, 3b) angeordnet sind;
- eine erste dielektrische Schicht (4a), erste Dotierungsstoffe eines ersten Typs in einem Restverhältnis umfassend, die auf dem texturierten Bereich (ZT) der ersten Oberfläche (10) des Substrats (1) gebildet ist;
- eine zweite dielektrische Schicht (4b), zweite Dotierungsstoffe eines zweiten Typs, der zu dem ersten Typ entgegengesetzt ist, in einem Restverhältnis umfassend, die auf der zweiten Polysiliciumschicht (3b) gebildet ist;
- erste und zweite mit dem ersten Typ dotierte halbleitende Regionen (R1, R2), die sich unter der ersten Oberfläche (10) des Substrat (1) erstrecken, wobei sie dem ersten Tunneloxidfilm (2a) beziehungsweise der ersten dielektrischen Schicht (4a) gegenüberliegen;
- eine dritte mit dem zweiten Typ dotierte halbleitende Region (R3), die sich unter der zweiten Oberfläche (11) des Substrats (1) erstreckt.

## Claims

1. Process for manufacturing a photovoltaic cell, comprising the following successive steps:
a) providing a structure comprising:
- a substrate (1) based on crystalline silicon, having a first surface (10) and an opposite second surface (11) each comprising a polished region (ZP) and a textured region (ZT);
- first and second tunnel-oxide films (2a, 2b), formed on the polished region (ZP) of the first and second surfaces (10, 11) of the substrate (1), respectively;
- first and second polysilicon layers (3a, 3b) formed on the first and second tunnel-oxide films (2a, 2b), respectively;
- a first dielectric layer (4a), comprising p-type dopants, said first dielectric layer being formed on the textured region (ZT) of the first surface (10) of the substrate (1) and on the first polysilicon layer (3a);
- a second dielectric layer (4b), comprising n-type dopants, said second dielectric layer being formed on the textured region (ZT) of the second surface (11) of the substrate (1) and on the second polysilicon layer (3b);
b) applying a heat treatment to the structure, said heat treatment being configured to:
- diffuse the p-type dopants under the first surface (10) of the substrate (1), from the first dielectric layer (4a) formed on the first polysilicon layer (3a), through the first polysilicon layer (3a) and the first tunnel-oxide film (2a), so as to form a first doped semiconductor region (R1);
- diffuse the p-type dopants under the first surface (10) of the substrate (1), from the first dielectric layer (4a) formed on the textured region (ZT) of the first surface (10) of the substrate (1), so as to form a second doped semiconductor region (R2);
- diffuse the n-type dopants under the second surface (11) of the substrate (1), from the second dielectric layer (4b) formed on the second polysilicon layer (3b), through the second polysilicon layer (3b) and the second tunnel-oxide film (2b), so as to form a third doped semiconductor region (R3);
- diffuse the n-type dopants under the second surface (11) of the substrate (1), from the second dielectric layer (4b) formed on the textured region (ZT) of the second surface (11) of the substrate (1), so as to form a fourth doped semiconductor region (R4);
c) bringing each of the first and second polysilicon layers (3a, 3b) into contact with an electrode (E).

2. Process according to Claim 1, wherein the heat treatment applied in step b) is configured so that:
- the first doped semiconductor region (R1) has a first depth of between 30 nm and 200 nm;
- the second doped semiconductor region (R2) has a second depth strictly greater than the first depth, and less than or equal to 1 µm;
- the third doped semiconductor region (R3) has a third depth of between 30 nm and 200 nm;
- the fourth doped semiconductor region (R4) has a fourth depth strictly greater than the third depth, and less than or equal to 1 µm.

3. Process according to Claim 1 or 2, wherein step a) is executed so that:
- the p-type dopants comprise boron atoms;
- the n-type dopants comprise phosphorous atoms;
and the heat treatment applied in step b) is a thermal anneal having an annealing-temperature value between 900°C and 1000°C.

4. Process according to Claim 3, wherein the thermal anneal has an annealing-time value between 10 minutes and 3 hours, and preferably between 30 minutes and 90 minutes.

5. Process according to Claim 3 or 4, wherein step a) is executed so that:
- the boron atoms have an atomic proportion in the first dielectric layer of between 10% and 50%, and preferably of between 10% and 30%;
- the phosphorus atoms have a mass proportion in the second dielectric layer greater than or equal to 4%, and preferably of between 10% and 30%.

6. Process according to one of Claims 1 to 5, wherein step a) is executed so that:
- the first dielectric layer (4a) is based on a, preferably hydrogenated, silicon oxynitride SiOₓN_{y} verifying 0≤y<x;
- the second dielectric layer (4b) is based on a, preferably hydrogenated, silicon oxynitride SiOₓN_{y} verifying 0≤x<y;
- the first and second tunnel-oxide films (2a, 2b) are based on a silicon oxide or aluminium oxide, and each have a thickness less than or equal to 3 nm, and preferably less than or equal to 2 nm.

7. Process according to one of Claims 1 to 6, wherein step a) is executed so that the first dielectric layer (4a) and/or the second dielectric layer (4b) are covered with an anti-reflection layer (ARC), the anti-reflection layer (ARC) preferably being a silicon oxynitride or a silicon nitride.

8. Process according to one of Claims 1 to 7, wherein step a) is executed so that the textured region (ZT) of the first surface (10) of the substrate (1) is covered with an alumina layer (5), the alumina layer (5) preferably having a thickness of between 3 nm and 8 nm.

9. Process according to one of Claims 1 to 8, wherein step a) is executed so that the second dielectric layer (4b), formed on the textured region (ZT) of the second surface (11) of the substrate (1), is covered with an alumina layer (5), the alumina layer (5) preferably having a thickness of between 2 nm and 6 nm.

10. Process according to one of Claims 1 to 9, wherein the first and second dielectric layers (4a, 4b) are kept after step b).

11. Process according to one of Claims 1 to 10, wherein step c) comprises the following steps:
c₁) forming, on the first and second polysilicon layers (3a, 3b), a screen-printing paste (Pₛ) possessing a baking temperature;
c₂) applying a heat treatment to the structure, at the baking temperature of the screen-printing paste (Pₛ).

12. Process according to one of Claims 1 to 11, wherein step a) comprises the following steps:
a₁) providing a substrate (1) based on crystalline silicon, having a first surface (10) and an opposite second surface (11);
a₂) polishing the first and second surfaces (10, 11) of the substrate (1); then forming the first and second tunnel-oxide films (2a, 2b) and the first and second polysilicon layers (3a, 3b);
a₃) forming an etch mask (M) on the first and second polysilicon layers (3a, 3b), delineating a region to be textured (ZT);
a₄) texturing the first and second surfaces (10, 11) of the substrate (1) through the etch mask (M) so as to form the textured region (ZT).

13. Process for manufacturing a photovoltaic cell, comprising the following successive steps:
a') providing a structure comprising:
- a substrate (1) based on crystalline silicon, having a first surface (10) and an opposite second surface (11), the first surface (10) comprising a polished region (ZP) and a textured region (ZT), the second surface (11) being polished;
- a first tunnel-oxide film (2a), formed on the polished region (ZP) of the first surface (10) of the substrate (1);
- a second tunnel-oxide film (2b), formed on the polished second surface (11) of the substrate (1);
- first and second polysilicon layers (3a, 3b) formed on the first and second tunnel-oxide films (2a, 2b), respectively;
- a first dielectric layer (4a), comprising first dopants of a first type, said first dielectric layer being formed on the textured region (ZT) of the first surface (10) of the substrate (1) and on the first polysilicon layer (3a);
- a second dielectric layer (4b), comprising second dopants of a second type opposite the first type, said second dielectric layer being formed on the second polysilicon layer (3b);
b') applying a heat treatment to the structure, said heat treatment being configured to:
- diffuse the first dopants under the first surface (10) of the substrate (1), from the first dielectric layer (4a) formed on the first polysilicon layer (3a), through the first polysilicon layer (3a) and the first tunnel-oxide film (2a), so as to form a first doped semiconductor region (R1);
- diffuse the first dopants under the first surface (10) of the substrate (1), from the first dielectric layer (4a) formed on the textured region (ZT) of the first surface (10) of the substrate (1), so as to form a second doped semiconductor region (R2);
- diffuse the second dopants under the second surface (11) of the substrate (1), from the second dielectric layer (4b), through the second polysilicon layer (3b) and the second tunnel-oxide film (2b), so as to form a third doped semiconductor region (R3);
c') bringing each of the first and second polysilicon layers (3a, 3b) into contact with an electrode (E).

14. Photovoltaic cell, comprising:
- a substrate (1) based on crystalline silicon, having a first surface (10) and an opposite second surface (11) each comprising a polished region (ZP) and a textured region (ZT);
- first and second tunnel-oxide films (2a, 2b), formed on the polished region (ZP) of the first and second surfaces (10, 11) of the substrate (1), respectively;
- first and second polysilicon layers (3a, 3b) formed on the first and second tunnel-oxide films (2a, 2b), respectively;
- first and second electrodes (E), arranged in contact with the first and second polysilicon layers (3a, 3b), respectively;
- a first dielectric layer (4a), comprising p-type dopants in a residual proportion, said first dielectric layer being formed on the textured region (ZT) of the first surface (10) of the substrate (1);
- a second dielectric layer (4b), comprising n-type dopants in a residual proportion, said second dielectric layer being formed on the textured region (ZT) of the second surface (11) of the substrate (1);
- first and second p-type doped semiconductor regions (R1, R2), lying under the first surface (10) of the substrate (1), and facing the first tunnel-oxide film (2a) and the first dielectric layer (4a), respectively;
- third and fourth n-type doped semiconductor regions (R3, R4), lying under the second surface (11) of the substrate (1), and facing the second tunnel-oxide film (2b) and the second dielectric layer (4b), respectively.

15. Photovoltaic cell, comprising:
- a substrate (1) based on crystalline silicon, having a first surface (10) and an opposite second surface (11), the first surface (10) comprising a polished region (ZP) and a textured region (ZT), the second surface (11) being polished;
- a first tunnel-oxide film (2a), formed on the polished region (ZP) of the first surface (10) of the substrate (1);
- a second tunnel-oxide film (2b), formed on the polished second surface (11) of the substrate (1);
- first and second polysilicon layers (3a, 3b) formed on the first and second tunnel-oxide films (2a, 2b), respectively;
- first and second electrodes (E), arranged in contact with the first and second polysilicon layers (3a, 3b), respectively;
- a first dielectric layer (4a), comprising first dopants of a first type in a residual proportion, said first dielectric layer being formed on the textured region (ZT) of the first surface (10) of the substrate (1);
- a second dielectric layer (4b), comprising second dopants of a second type opposite the first type in a residual proportion, said second dielectric layer being formed on the second polysilicon layer (3b);
- first and second doped semiconductor regions (R1, R2) of the first type, lying under the first surface (10) of the substrate (1), and facing the first tunnel-oxide film (2a) and the first dielectric layer (4a), respectively;
- a third doped semiconductor region (R3) of the second type, lying under the second surface (11) of the substrate (1).
